# EUROPEAN PATENT APPLICATION

(11) **EP 3 742 611 A1**
(43) Date of publication of application: **25.11.2020**
(21) Application number: 19175529.7
(22) Date of filing: 21.05.2019
(51) Int. Cl.: H03H 7/01, H03H 7/38, H01F 29/00, H03B 5/12

(54) **IMPEDANCE MATCHING CIRCUIT, RADIO FREQUENCY CIRCUIT AND METHOD**

(71) Applicant: Infineon Technologies AG, 85579 Neubiberg (DE)
(72) Inventor: BAKALSKI, Winfried, 85640 Putzbrunn (DE)
(74) Representative: Sticht, Andreas

(57) **Abstract**

An impedance matching circuit (11) is provided comprising a plurality of branches between an input node (19) and an output node (13). Each branch comprises an inductor (14A-14C) coupled in series to a series switch (16A-16C) and coupled in parallel to a parallel switch (15A-15C). Each first end of a respective inductor may be a first radio frequency output terminal.

## Description

### TECHNICAL FIELD

The present application relates to impedance matching circuits, radio frequency circuits and corresponding methods.

### BACKGROUND

Impedance matching circuits relate to techniques for designing or adjusting an input impedance of an electrical load that receives a signal or an output impedance of a corresponding signal source to maximize power transfer to or minimize signal reflection from the load. The impedance usually is a complex number and may have resistive, capacitive, and inductive components. Generally, the higher the frequency of signals involved is, the higher is the importance of capacitive and inductive components to the impedance. Therefore, usually, impedance matching requires tunable capacitors and/or tunable inductors.

While there are many well established approaches for tunable capacitors, providing tunable inductors provides a bigger challenge. One approach for providing tunable inductors includes an indirect tuning of inductors by a series or parallel connection to a tunable capacitance. A problem occurring with such an approach is that it is limited by self resonance between the capacitor and the inductor, as capacitor and inductor form a resonant circuit. Another approach uses a plurality of switched inductors coupled in parallel. In this case, each inductor has an associated switch in series thereto, which selectively activates or deactivates the corresponding inductor. Switches are usually formed by transistors, which in an off state have an inherent parasitic capacitance. Due to this inherent capacitance, again the problem of self resonance may occur.

To remove the problem of self resonances, various approaches have been used. In one approach, various tuning circuits each including inductors are used in parallel. Each tuning circuit is only used in a certain frequency range where no self resonance may occur. However, this approach causes additional losses. Other approaches use inductors one end of which is fixedly coupled to ground, where the other end may be shunted to ground for deactivation. However, this approach limits circuit design, as only inductors coupled to ground may be used. Furthermore, due to the switches used, a high capacitance is coupled to a common output terminal of the inductors.

### SUMMARY

An impedance matching circuit as defined in claim 1, a radio frequency circuit as defined in claim 6 and a method as defined in claim 14 are provided. The dependent claims define further embodiments.

According to an embodiment, an impedance matching circuit is provided, comprising:
an input node,
an output node, and
a plurality of branches coupled in parallel between the input node and the output node, each branch of the plurality of branches comprising:
   an inductor,
   a series switch coupled in series to the inductor, and
   a parallel switch coupled in parallel to the inductor.

According to another embodiment, a radio frequency circuit is provided, comprising:
a radio frequency input terminal,
a plurality of first radio frequency output terminals,
a second radio frequency output terminal,
a plurality of series switches, each series switch being coupled between the radio frequency input terminal and a respective one of the first radio frequency output terminals, and
a plurality of parallel switches, each of the plurality of parallel switches being coupled between a respective one of the first radio frequency output terminals and the second radio frequency output terminal.

According to a further embodiment, a method of operating an impedance matching circuit is provided, comprising: adjusting series switches of a plurality of branches, each series switch being coupled in series to an inductor of the respective branch, and
adjusting parallel switches of the plurality of branches, each parallel switch being coupled in parallel to a respective one of the inductors.

The above summary is merely intended to give a brief overview over some embodiments and is not to be construed as limiting in any way.

### BRIEF DESCRIPTION OF THE DRAWINGS

Fig. 1 is a circuit diagram illustrating an impedance matching circuit according to an embodiment.
Fig. 2A is a circuit diagram illustrating a system including a radio frequency circuit according to an embodiment.
Fig. 2B illustrates internal circuitry of the radio frequency circuit of Fig. 2A.
Fig. 3 is a flowchart illustrating a method according to an embodiment.

### DETAILED DESCRIPTION

In the following, various embodiments will be described in detail referring to the attached drawings. These embodiments are to be taken as illustrative examples only and are not to be construed as limiting. For example, while embodiments may be described as comprising numerous features, in other embodiments some of these features may be omitted or may be replaced by alternative features. In addition to the features explicitly shown in the drawings or described herein, additional features, for example features provided in conventional impedance matching circuits or radio frequency circuits, may be provided.

Variations and modifications described with respect to one of the embodiments may also be applied to other embodiments and will therefore not be described repeatedly. Features from different embodiments may be combined to form further embodiments.

Some embodiments relate to radio frequency (RF) circuits. Radio frequency, in this respect, may refer to frequencies above 1 MHz, for example 100 MHz or more or in the GHz range.

Some embodiments use switches. A switch is on or closed when it provides an electrical connections between its terminals, and off or open when it provides essentially an electric isolation between its terminals (apart from possible small leakage currents which may occur in some switch implementations). Switches may be implanted as transistor switches, for example field effect transistors like MOSFETs, insolated gate bipolar transistors or bipolar junction transistors but also MEMS.

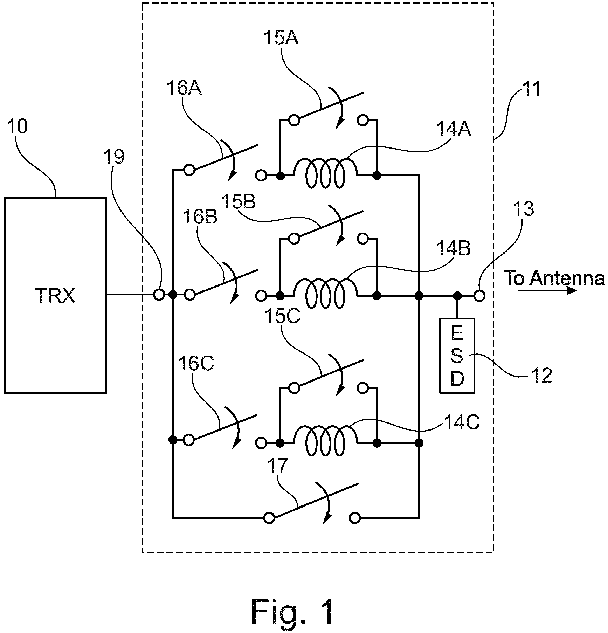

Turning now to the figures, Fig. 1 illustrates an impedance matching circuit 11 according to an embodiment. As an application example, in Fig. 1 an input node 19 of the impedance matching circuit 11 is coupled to an output of a radio frequency transmit circuit 10, whereas an output node 13 of impedance matching circuit 11 is coupled to an antenna (indicated by an arrow in Fig. 1). However, application of impedance matching circuit 11 is not limited to this case but may be used in general in cases where a variable inductivity is required for impedance matching, for example also in other RF circuits.

Impedance matching circuit 11 comprises a plurality of circuit branches coupled in parallel between input node 19 and output node 13. In the example of Fig. 1, three such branches are shown. This is merely an example, and less or more branches may be provided in other embodiments.

Each of the branches comprises an inductor 14A, 14B, 14C, respectively. Inductors 14A, 14B, 14C may have the same or different inductance values. In some applications like mobile phone applications, the inductance values may be in the range from 1 to 100nH. In other applications, other values may be used.

In each of the branches, a series switch 16A, 16B, 16C, respectively, is coupled in series to the respective inductor 14A, 14B, 14C. Series switches 16A, 16B, 16C may be implemented as transistor switches. In embodiments, switches 16A, 16B, 16C may have a relatively low on resistance (i.e. resistance when the respective switch is closed) in order to provide a reasonably good Q factor. The Q factor is the imaginary part of the impedance, Im(Z), divided by the real part of the impedance, Re(Z), i.e. Q=Im(Z)/Re(Z)=jωL/R, where j is the imaginary unit, ω is the angular frequency of a signal applied at the input node 19, L is the inductivity and R is the ohmic resistance, which at least to a significant extent is influenced by the on resistance of series switches 16A, 16B, 16C.

Such a low on resistance may for example be obtained by a corresponding transistor design in case the switches are implemented as transistors. In some embodiments, for example in some mobile phone applications, the on resistance of series switches 16A, 16B, 16C may be below 5Ω, for example 1Ω or below. In other applications, other values may apply.

By selectively opening and closing series switches 16A, 16B, 16C, the overall inductivity of impedance matching circuit 11 may be adjusted. It should be noted that to provide a desired overall inductivity for impedance matching circuit 11, any combination of opened and closed switches may be used for switches 16A, 16B, 16C.

Furthermore, in parallel to each of inductors 14A, 14B, 14C, a respective parallel switch 15A, 15B, 15C is provided. When a respective switch 16A, 16B, 16C of a branch is closed, the respective parallel switch 15A, 15B, 15C of the respective branch is opened and vice versa. Closing the parallel switch provides an essentially ohmic connection between the ends of the respective inductor 14A, 14B, 14C, which in embodiments strongly reduces the Q factor for the respective branch and avoids or at least reduces self resonances. Each of parallel switches 15A, 15B, 15C may have a comparatively high on resistance, for example between 5 and 20 Ω, like between 10 and 15 Ω. Such a comparatively high on resistance enables a use of comparatively small transistors for implanting parallel switches 1A, 15B, 15C, which reduces the area required for the switches on a semiconductor chip. Furthermore, using small transistors for switches 15A, 15B, 15C may lead to a small parasitic capacitance of these switches, which in turn reduces or avoids parallel self resonances. Therefore, in some embodiments an on resistance of parallel switches 15A to 15C is higher than an on resistance of series switches 16A to 16C.

Optionally, impedance matching circuit 11 may comprise a bypass switch 17 coupled between input node 19 and output node 13. By closing pass switch 17, an essentially ohmic connection, in particular low ohmic connection, may be provided between input node 19 and output node 13. In embodiments, when bypass switch 17 is closed, series switch 16A to 16C may be opened, and parallel switches 15A to 15C may be closed.

As a further optional circuit, an electrostatic discharge (ESD) protection circuit 12 may be provided coupled to output node 13. ESD protection circuit 12 may be implemented in any conventional manner using for example one or more switches or diodes to shunt charge due to an ESD event occurring at output node 13 to a reference positional like ground. In addition to the adjustable inductivity provided by impedance matching circuit 11 as shown, further components like adjustable capacitors or adjustable resistors may be included in impedance matching circuit 11 in other embodiments.

As explained above, with impedance matching circuit 11, an adjustable inductivity with avoided or reduced self resonances may be provided.

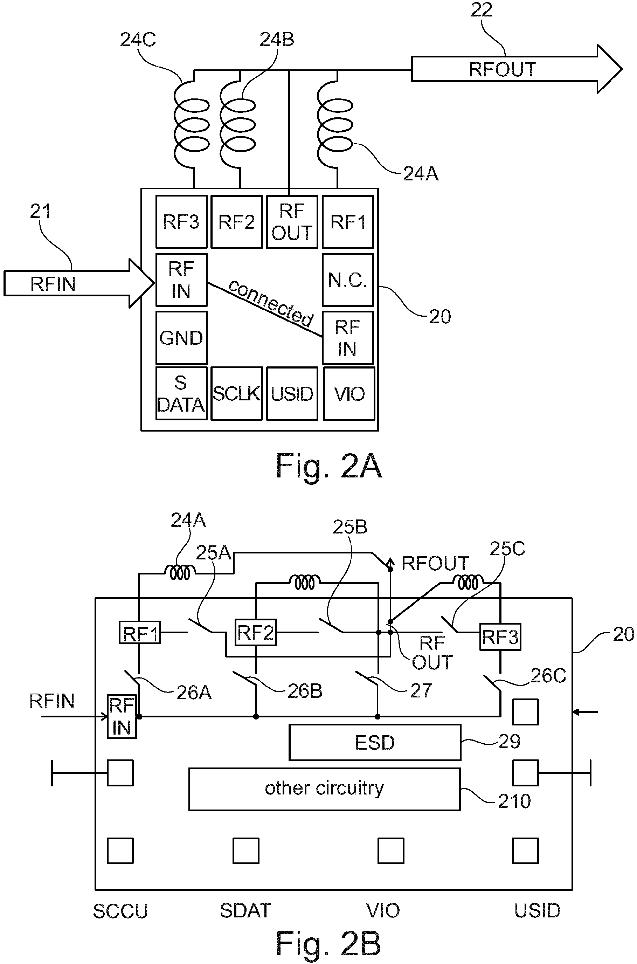

Switches of an impedance matching circuit according to an embodiment, like switches 15A to 15C, 16A to 16C and 17 as well as possible switches used for ESD protection circuit 12, may be provided in an integrated circuit, possibly together with other components, whereas inductors like inductors 14A, 14B, 14C may be provided as components external to such an integrated circuit. An example for such a configuration will be explained next referring to Figs. 2A and 2B. However, other configurations may be used as well.

Fig. 2A shows a system including an integrated circuit 20. Integrated circuit 20 may be provided in a package, which in the example of Fig. 2A may have twelve pins. Pins SDATA SCLK, USID, VIO serve for communication, receiving a clock signal, receiving data etc. and may be used to provide functions in addition to the impedance matching function and/or to receive control signals, for example via a bus, controlling switches explained further below with respect to Fig. 2B for impedance matching. In some embodiments, the bus may be a digital bus used for controlling the switches explained below. Also, if a ESD switch is provided as also explained below, this switch may also be controlled to be opened or closed by an external control signal in addition to control by an ESD event. Such a control of an ESD switch may be used for calibration purposes as the ESD switch, when closed, provides a defined short circuit connection between terminals the ESD switch is connected to and may e.g. be used to calculate electric lengths of cables, tracks etc. Furthermore, integrated circuit 20 comprised a ground pin GND and a reserve pin which is not connected (N.C.).

Furthermore, integrated circuit 20 comprised two RF input terminals RF IN configured to receive an RF input signal as indicated by an arrow 21. The two RF input pins are connected with each other as indicated in Fig. 2A, such that either may be used for inputting a radio frequency input signal. Furthermore, integrated circuit 20 comprises three first RF output pins RF1, RF2 and RF3 and a second RF output pin RF OUT. As illustrated in Fig. 2A, each of first RF output pins RF1, RF2, RF3 is coupled to a respective inductor 24A, 24B, 24C, respectively. Second ends of inductors 24A, 24B and 24C are coupled to second RF output pin RF OUT. At the second ends and therefore also at the second RF output pin RF OUT, as indicated by an arrow 22 a radio frequency output signal may be tapped.

The number of three first RF output pins and the corresponding number of three inductors 24A to 24C is merely as an example, and any other number may also be provided. Similar to what was explained for inductors 14A to 14C of Fig. 1, using inductors 24A to 24C and switches provided with an integrated circuit 20, impedance matching may be provided. This will now be explained in some more detail referring to Fig. 2B, where an equivalent circuit of integrated circuit 20 showing corresponding switches is provided.

In Fig. 2B, a respective series switch 26A, 26B, 26C is provided between the RF input terminal RF IN and each of first RF output terminals RF1, RF2, RF3. Moreover, a respective parallel switch 25A, 25B, 25C is provided between each of first RF output terminals RF1, RF2, RF3 and second RF output terminal RF OUT. Similar to what has been explained for series switches 16A to 16C and parallel switches 15A to 15C of Fig. 1, series switches 26A to 26C may be designed to have a low on resistance, for example be designed as correspondingly large transistors, whereas parallel switches 25A to 25C may be designed to have a comparatively high on resistance, for example as correspondingly small transistors. Furthermore, a bypass switch 27 is provided in Fig. 2B between RF input terminal RF IN and second RF output terminal RF OUT. With inductors 24A to 24C, series switches 26A to 26C, parallel switches 25A to 25C and bypass switch 27 an impedance matching circuit similar to the one shown in Fig. 1 is implemented and the explanations made with reference to Fig. 1 also apply to the impedance matching circuit of Fig. 2B.

The layout of integrated circuit 20 may be similar to the equivalent circuit of Fig. 2B. Parallel switches 25A to 25C may be provided adjacent to an edge of integrated circuit 20 where the first and second RF output terminals are provided and series switches 26A and 26C as well as bypass switch 27 may be provided adjacent thereto. Further adjacent, as shown in Fig. 2B, as ESD circuit 29 coupled to second output terminal RF OUT may be provided, for example in form of an NMOS transistor. Further away from the first edge where first and second RF output terminals RF1 to RF3, RF OUT are provided, other circuitry 210 may be provided coupled to terminals SDATA, SCLK, USID, VIO to provide further functions. Nevertheless, also other layouts are possible. A stacking in the chip design may be dependent on the maximum voltage swing seen on the terminals. The higher the impedance mismatch when using the chip for impedance mismatch is, the higher the voltage swing may be. However, the voltage swing is limited by losses, and the higher losses in the cable are the lower the resulting voltage swing is, which may be taken into account in the chip design.

Simulations have been performed to compare an impedance matching circuit as shown in Fig. 1 with a conventional solution without the parallel switches 15A to 15B. The simulation showed that voltage stress due to self resonance has been reduced. For example, in a simulation without the parallel switches voltages up to 100 V occurred for an example RF input signal due to self resonances, which was reduced to 56 V where the parallel switches were used. This may reduce stress on the transistors and may increase lifetime of the transistors used as switches and/or may enable the use of smaller transistors.

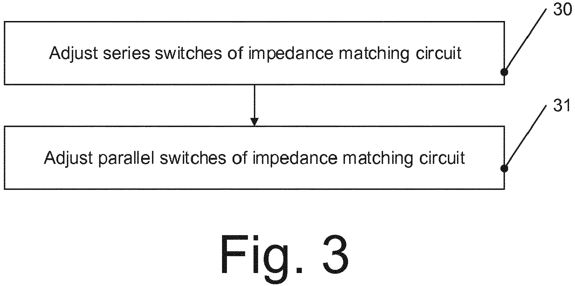

Fig. 3 illustrates a method according to an embodiment. The method of Fig. 3 may be implemented using the impedance matching circuit of Fig.1 or the integrated circuit of Figs. 2A and 2B, and will be described referring to the previous explanations. However, the method of Fig. 3 may also be implemented using other configurations.

While the method is depicted as a series of acts or events for better understanding, the order in which these acts or events is shown and described is not to be construed as limiting. In particular, the acts or events described may also be performed simultaneously or in other order than the order shown.

At 30, the method comprises adjusting serial switches of an impedance matching circuit, i.e. serial switches which are coupled in series to inductors in a plurality of parallel branches in the impedance matching circuit, as explained for series switches 16A to 16C of Fig. 1 or series switches 26A to 26C of Fig. 2B. The series switches may be opened and closed selectively to adjust the overall impedance of the impedance matching circuit.

At 31, the method comprises adjusting parallel switches of the impedance matching circuit, i.e. switches coupled in parallel to the inductors of the impedance matching circuit as explained for parallel switches 15A to 15C of Fig. 1 or 25A to 25C of Fig. 2B. For branches where the respective series switch is closed at 30, at 31 the respective parallel switch is opened, and for branches where the series switch is opened at 30, the respective parallel switch is closed at 31. As already explained previously with respect to Figs. 1 and 2, in this way self resonances may be reduced or avoided in some embodiments.

Some embodiments are defined by the following examples:
Example 1: An impedance matching circuit, comprising:
   an input node,
   an output node, and
   a plurality of branches coupled in parallel between the input node and the output node, each branch of the plurality of branches comprising:
      an inductor,
      a series switch coupled in series to the inductor, and a parallel switch coupled in parallel to the inductor.
Example 2: The impedance matching circuit of example 1, further comprising a bypass switch coupled between the input node and the output node.
Example 3: The impedance matching circuit of example 1 or 2, further comprising an electrostatic discharge protection circuit coupled to the output node.
Example 4: The impedance matching circuit of any one of examples 1 to 3, wherein an on resistance of the parallel switch is higher than an on resistance of the series switch.
Example 5: The impedance matching circuit of any one of examples 1 to 4, wherein an on resistance of the parallel switch is between 5 Ω and 20 Ω.
Example 6: The impedance matching circuit of example 5, wherein the on resistance of the parallel switch is between 10 Ω and 15 Ω.
Example 7: A system, comprising:
   the impedance matching circuit of any one of examples 1 to 6, a communication circuit coupled to the first node of the impedance matching circuit, and
   an antenna coupled to the second node of the impedance matching circuit.
Example 8: A radio frequency circuit, comprising:
   a radio frequency input terminal,
   a plurality of first radio frequency output terminals,
   a second radio frequency output terminal,
   a plurality of series switches, each series switch being coupled between the radio frequency input terminal and a respective one of the first radio frequency output terminals, and
   a plurality of parallel switches, each of the plurality of parallel switches being coupled between a respective one of the first radio frequency output terminals and the second radio frequency output terminal.
Example 9: The circuit of example 8, further comprising a bypass switch coupled between the radio frequency input terminal and the second radio frequency output terminal.
Example 10: The circuit of example 8 or 9, wherein each of the first radio frequency output terminals is configured to be coupled to a first end of a respective inductor, and wherein the second radio frequency output terminal is configured to be coupled to second ends of the inductors.
Example 11: The circuit of any one of examples 8 to 10, where the parallel switches have a higher on resistance than the series switches.
Example 12: The circuit of any one of examples 8 to 11, wherein the parallel switches have an on resistance between 5 Ω and 20 Ω.
Example 13: The circuit of any one of examples 8 to 12, wherein the circuit is an integrated circuit.
Example 14: The circuit of example 13, wherein the first radio frequency output terminals and the second radio frequency output terminal are arranged along a first edge of the integrated circuit, and wherein the plurality of parallel switches is arranged adjacent to the first edge.
Example 15: The circuit of example 14, wherein the plurality of series switches is arranged adjacent to the plurality of parallel switches.
Example 16: A system, comprising:
   the circuit of any one of examples 8 to 15, and
   a plurality of inductors, wherein a first end of each of the plurality of inductors is coupled to a respective first radio frequency output terminal, and
   wherein second ends of the plurality of inductors are coupled to the second radio frequency output terminal.
Example 17: A method of operating an impedance matching circuit, comprising:
   adjusting series switches of a plurality of branches, each series switch being coupled in series to an inductor of the respective branch, and
   adjusting parallel switches of the plurality of branches, each parallel switch being coupled in parallel to a respective one of the inductors.
Example 18: The method of examples 17, wherein, when a series switch of a branch is closed, the parallel switch of the branch is opened, and when the series switch of a branch is opened, the parallel switch of the branch is closed.
Example 19: The method of examples 17 or 18, wherein the impedance matching circuit is the impedance matching circuit of any one of examples 1 to 7.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. An impedance matching circuit (11), comprising:
an input node (17),
an output node (13), and
a plurality of branches coupled in parallel between the input node (19) and the output node (13), each branch of the plurality of branches comprising:
an inductor (14A-14C; 24A-24C),
a series switch (16A-16C; 26A-26C) coupled in series to the inductor (14A-14C; 24A-24C), and
a parallel switch (15A-15C; 25A-25C) coupled in parallel to the inductor.

2. The impedance matching circuit (11) of claim 1, further comprising a bypass switch (17; 27) coupled between the input node (19) and the output node (13).

3. The impedance matching circuit (11) of claim 1 or 2, further comprising an electrostatic discharge protection circuit (12; 29) coupled to the output node (13).

4. The impedance matching circuit (11) of any one of claims 1 to 3, wherein an on resistance of the parallel switch (15A-15C; 25A-25C) is higher than an on resistance of the series switch (16A-16C; 26A-26C).

5. A system, comprising:
the impedance matching circuit (11) of any one of claims 1 to 4,
a communication circuit (10) coupled to the first node (17) of the impedance matching circuit (11), and
an antenna coupled to the second node (13) of the impedance matching circuit.

6. A radio frequency circuit (20), comprising:
a radio frequency input terminal (RF IN),
a plurality of first radio frequency output terminals (RF1-RF3),
a second radio frequency output terminal (RF OUT),
a plurality of series switches (26A-26C), each series switch being coupled between the radio frequency input terminal (RF IN) and a respective one of the first radio frequency output terminals (RF1-RF3), and
a plurality of parallel switches (25A-25C), each of the plurality of parallel switches (25A-25C) being coupled between a respective one of the first radio frequency output terminals (RF1-RF3) and the second radio frequency output terminal (RF OUT).

7. The circuit (20) of claim 6, further comprising a bypass switch (27) coupled between the radio frequency input terminal (RF IN) and the second radio frequency output terminal (RF OUT).

8. The circuit of claim 6 or 7, wherein each of the first radio frequency output terminals (RF1-RF3) is configured to be coupled to a first end of a respective inductor (24A-24C), and wherein the second radio frequency output terminal (RF OUT) is configured to be coupled to second ends of the inductors (24A-24C).

9. The circuit of any one of claims 6 to 8, where the parallel switches (25A-25C) have a higher on resistance than the series switches (26A-26C).

10. The circuit of any one of claims 6 to 9, wherein the circuit is an integrated circuit.

11. The circuit of claim 10, wherein the first radio frequency output terminals (RF1-RF3) and the second radio frequency output terminal (RF OUT) are arranged along a first edge of the integrated circuit, and wherein the plurality of parallel switches (25A-25C) is arranged adjacent to the first edge.

12. The circuit of claim 11, wherein the plurality of series switches (26A-26C) is arranged adjacent to the plurality of parallel switches (25A-25C).

13. A system, comprising:
the circuit of any one of claims 6 to 12, and
a plurality of inductors (24A-24C), wherein a first end of each of the plurality of inductors is coupled to a respective first radio frequency output terminal (RF1-RF3), and
wherein second ends of the plurality of inductors are coupled to the second radio frequency output terminal.

14. A method of operating an impedance matching circuit (11), comprising:
adjusting series switches (16A-16C; 26A-26C) of a plurality of branches, each series switch (16A-16C; 26A-26C) being coupled in series to an inductor (14A-14C; 24A-24C) of the respective branch, and
adjusting parallel switches (15A-15C; 25A-25C) of the plurality of branches, each parallel switch being coupled in parallel to a respective one of the inductors.

15. The method of claim 14, wherein, when a series switch (16A-16C; 26A-26C) of a branch is closed, the parallel switch (15A-15C; 25A-25C) of the branch is opened, and when the series switch (16A-16C; 26A-26C) of a branch is opened, the parallel switch (15A-15C; 25A-25C) of the branch is closed.
